# EUROPÄISCHE PATENTSCHRIFT

(11) **EP 3 771 044 B1**
(45) Veröffentlichungstag und Bekanntmachung des Hinweises auf die Patenterteilung: **16.03.2022**
(21) Anmeldenummer: 19188247.1
(22) Anmeldetag: 25.07.2019
(51) Int. Cl.: H01R 13/53, H01R 13/11, H01R 13/631, H01R 24/76, H01R 105/00

(54) **VERBINDER FÜR EINE PRÜFEINHEIT EINES MOTORPRÜFSTANDES**
CONNECTOR FOR A TEST UNIT OF A MOTOR TEST BENCH
CONNECTEUR POUR UNE UNITÉ D'ESSAI D'UN BANC D'ESSAI DE MOTEUR

(43) Veröffentlichungstag der Anmeldung: 27.01.2021
(73) Patentinhaber: MLT Maschinen Leitungstechnik GmbH, 4592 Leonstein (AT)
(72) Erfinder: ROHRAUER, Michael, 4591 Molln (AT)
(74) Vertreter: KLIMENT & HENHAPEL

(56) Entgegenhaltungen:
- CN-B- 105 655 806
- DE-U1-202018 105 926

## Beschreibung

Die Erfindung betrifft einen Verbinder für eine Prüfeinheit eines Motorprüfstandes, wobei mit elektrischen Versorgungskabeln des Verbinders elektrisch verbundene Kontaktstifte des Verbinders in einer Kontaktierungsrichtung zum Herstellen und Trennen eines elektrischen Kontakts zu Versorgungssteckern eines zu prüfenden Elektromotors bewegbar sind, wobei der Verbinder einen Verbinderkopf und einen in Kontaktierungsrichtung bewegbaren Verbinderrahmen umfasst, und die Kontaktstifte am Verbinderkopf angeordnet sind, gemäß dem Oberbegriff von Anspruch 1, sowie einen Motorprüfstand mit einem erfindungsgemäßen Verbinder.

Motorprüfstände für Elektromotoren dienen in bekannter Weise in der Prüf- und Messtechnik zum Prüfen von Elektromotoren, indem beispielsweise mithilfe vorgegebener Prüfprogramme unterschiedliche Betriebszustände des Elektromotors simuliert und das ordnungsgemäße Funktionieren des Elektromotors überprüft wird. Hierfür muss der Elektromotor mit Strom versorgt werden, wofür ein Verbinder vorgesehen ist. Unterschiedliche Ausführungen eines Verbinders wurden in der DE 20 2018 105926 U1 und der CN 105 655 806 B beschrieben. Der Verbinder weist Kontaktstifte auf, die mit den Versorgungssteckern des Elektromotors elektrisch kontaktiert werden können, indem die Kontaktstifte in eine vorwärts gerichtete Kontaktierungsrichtung bewegt werden. Durch eine Bewegung der Kontaktstifte in eine rückwärts gerichtete Kontaktierungsrichtung kann der elektrische Kontakt wieder gelöst werden. Der elektrische Kontakt wird dabei zumeist über eine federnde, bauteilschonende Steckverbindung hergestellt, indem stift- oder hülsenförmig ausgeführte Kontaktstifte des Verbinders in entsprechend gegengleich ausgeführte stift- oder hülsenförmige Versorgungsstecker des zu prüfenden Elektromotors reibungslos aufgesteckt oder stirnseitig angedrückt werden. Die Längsachsen der stift- oder hülsenförmig ausgeführten Kontaktstifte definieren dabei die Kontaktierungsrichtung.

Der elektrische Kontakt muss dabei zuverlässig und vollständig hergestellt werden, bevor die Prüfprogramme gestartet werden können. Bei Elektromotoren sind dabei mitunter Leistungsübertragungen von bis zu 300A bei bis zu 400V erforderlich. Dabei dürfen die Versorgungsstecker des zu prüfenden Elektromotors in keiner Weise beschädigt werden, da der zu prüfende Elektromotor zumeist für den späteren Verkauf gedacht ist. Erschwert werden diese Vorgaben dadurch, dass seitens des Elektromotors Produktionstoleranzen hinsichtlich der Positionierung der Versorgungsstecker bestehen. Aufgrund dieser Produktionstoleranzen kann die Lage der Versorgungsstecker in einer zur Kontaktierungsrichtung senkrechten Ebene um bis zu 1.5mm variieren. Zudem können die Längsachsen der stift- oder hülsenförmig ausgeführten Versorgungsstecker eine Neigung gegenüber der Kontaktierungsrichtung von bis zu 2° aufweisen. Dadurch ergeben sich in der Praxis immer wieder Probleme mit einem unvollständigen Kontaktschluss oder mit einer mechanischen Belastung oder sogar Beschädigungen der Versorgungsstecker.

Es ist daher das Ziel der Erfindung einen Verbinder für Motorprüfstände so auszuführen, dass auch bei Auftreten von Produktionstoleranzen seitens des Elektromotors ein zuverlässiger und vollständiger elektrischer Kontakt zwischen den Kontaktstiften des Verbinders und den Versorgungsteckern des Elektromotors hergestellt wird, aber dennoch mechanische Belastungen und somit Beschädigungen der Versorgungsstecker bestmöglich vermieden werden können.

Dieses Ziel wird durch die Merkmale von Anspruch 1 erreicht. Anspruch 1 bezieht sich auf einen Verbinder für eine Prüfeinheit eines Motorprüfstandes, wobei mit elektrischen Versorgungskabeln elektrisch verbundene Kontaktstifte des Verbinders in einer Kontaktierungsrichtung zum Herstellen und Trennen eines elektrischen Kontakts zu Versorgungssteckern eines zu prüfenden Elektromotors bewegbar sind, wobei der Verbinder einen Verbinderkopf und einen in Kontaktierungsrichtung bewegbaren Verbinderrahmen umfasst, und die Kontaktstifte am Verbinderkopf angeordnet sind. Erfindungsgemäß wird hierbei vorgeschlagen, dass der Verbinderkopf über ein Kugelgelenk im Verbinderrahmen in Kontaktierungsrichtung relativ zum Verbinderrahmen lagefixiert und in einer zur Kontaktierungsrichtung senkrechten Ebene relativ zum Verbinderrahmen beweglich gelagert ist, und eine Ausrichteinheit zur Justierung des Verbinderkopfes in eine vorgegebene Lage relativ zum Verbinderrahmen vorgesehen ist, die aus einer Mehrzahl mechanischer Federelemente gebildet wird, die zwischen dem Verbinderkopf und dem Verbinderrahmen angeordnet sind, deren gemeinsame Gleichgewichtslage eine vorgegebene Lage des Verbinderkopfes definiert, sowie Spannbacken umfasst, die mittels steuerbarer Stellzylinder zwischen einer freigebenden Stellung, in der der Verbinderkopf in einer zur Kontaktierungsrichtung senkrechten Ebene bewegbar ist, in eine einspannende Stellung, in der der Verbinderkopf mittels der Spannbacken in einer vorgegebenen Lage fixiert ist, bewegbar sind. Die Kontaktstifte sind somit Teil eines Verbinderkopfes, der in einem Verbinderrahmen des Verbinders in einer zur Kontaktierungsrichtung senkrechten Ebene relativ zum Verbinderrahmen beweglich gelagert ist. Die Beweglichkeit wird zum Einen mithilfe eines Kugelgelenks sichergestellt, das den Verbinderkopf jedoch in Kontaktierungsrichtung relativ zum Verbinderrahmen lagefixiert hält, sodass die zumeist automatisiert vorgenommene Vorschubbewegung des Verbinders in Kontaktierungsrichtung nicht beeinträchtigt wird. Dabei kann ausgenutzt werden, dass bei üblicherweise verwendeten Steckverbindungen eine geringfügige Führung der verbinderseitigen Kontaktstifte durch die motorseitigen Versorgungsstecker gegeben ist. Bei Niederspannungsmotoren finden etwa Steckverbindungen Anwendung, bei denen eine Mehrzahl an Kontaktstiften des Verbinders von einem Rahmenteil umgeben sind, der im Zuge einer Vorschubbewegung in eine vorwärts gerichtete Kontaktierungsrichtung auf einen entsprechend ausgeführten Formteil des Elektromotors trifft, der die Versorgungsstecker des Elektromotors umgibt. Der Rahmenteil wird durch das Einschieben in den Formteil ausgerichtet, sodass in weiterer Folge die Kontaktstifte zielgenau an die Versorgungsstecker stirnseitig angedrückt werden können. Bei Hochspannungsmotoren finden dreipolige Versorgungsstecker Anwendung, die jeweils stiftförmig ausgeführt sind und jeweils von einer ringförmigen Aufnahme umgeben sind. Die drei Kontaktstifte des Verbinders weisen hierfür jeweils in axialer Richtung abstehende Kontaktlamellen auf, die eine Kontakthülse bilden und in radialer Richtung beweglich sind. Die Kontakthülsen sind jeweils von einer dem Kontakt zugehörigen Kunststoffhülse umgeben, und die Kontakthülsen sind innerhalb der Kunststoffhülsen relativ zu der dem Kontakt zugehörigen Kunststoffhülse sowie zum Rahmenteil axial beweglich und zumeist federnd gelagert. Jeder der drei Kontaktstifte ist des Weiteren von einer Kunststoff-Ausrichthülse umgeben, die am axial beweglichen Rahmenteil befestigt sind. Die am Rahmenteil fixierten Kunststoff-Ausrichthülsen und die jeweils innenliegenden, mit der Kunststoffhülse ummantelten Kontakthülsen mit den Kontaktlamellen eines verbinderseitigen Kontaktstiftes dringen dabei im Zuge einer Vorschubbewegung in eine vorwärts gerichtete Kontaktierungsrichtung in die motorseitig angeordneten ringförmigen Aufnahmen ein, wobei die ringförmigen Aufnahmen ein gewisses Maß an Führung bieten. Sobald der stiftförmige Versorgungsstecker den Boden der Kontakthülse mit den Kontaktlamellen trifft, wird die Kontakthülse mit den Kontaktlamellen relativ zur Kunststoffhülse axial verschoben und die Kontaktlamellen aufgrund einer entsprechenden Formgebung der Kunststoffhülse dadurch radial nach innen gedrückt. Die Kontaktlamellen legen sich somit im Zuge der Kontaktierung von außen an den Mantel der stiftförmig ausgeführten Versorgungsstecker an und stellen auf diese Weise den elektrischen Kontakt her.

Aufgrund der zuvor erwähnten Produktionstoleranzen kann es dabei zu Verklemmungen, einer unzureichenden Kontaktierung oder sogar zu Beschädigungen der Versorgungsstecker kommen, die erfindungsgemäß nun vermieden werden, da der die Kontaktstifte aufweisende Verbinderkopf in einer zur Kontaktierungsrichtung senkrechten Ebene beweglich gelagert ist und sich auf diese Weise im Zuge der vorwärts gerichteten Vorschubbewegung von den Versorgungssteckern führen lässt. Mechanische Belastungen, Verklemmungen oder sogar Beschädigungen der Versorgungsstecker können auf diese Weise vermieden werden. Um den Verbinderkopf nach dem Lösen der elektrischen Verbindung im Zuge einer Vorschubbewegung in eine rückwärts gerichtete Kontaktierungsrichtung wieder in eine vorgegebene Lage zu bewegen ist erfindungsgemäß ferner eine Ausrichteinheit zur Justierung des Verbinderkopfes in diese vorgegebene Lage relativ zum Verbinderrahmen vorgesehen. Zumeist wird es sich bei der vorgegebenen Lage um eine Nulllage handeln, also eine definierte Anfangslage des Verbinderkopfes, um genau definierte Anfangsbedingungen für ein vorgegebenes Prüfprogramm sicher zu stellen.

Die Ausrichteinheit wird erfindungsgemäß aus einer Mehrzahl mechanischer Federelemente gebildet, die zwischen dem Verbinderkopf und dem Verbinderrahmen angeordnet sind, deren gemeinsame Gleichgewichtslage eine vorgegebene Lage des Verbinderkopfes definiert.

Die Ausrichteinheit ist zudem auch als aktive Ausrichteinheit ausgeführt, bei der eine vorgegebene Lage des Verbinderkopfes aktiv angesteuert werden kann. Hierfür wird erfindungsgemäß vorgeschlagen, dass die Ausrichteinheit Spannbacken umfasst, die mittels steuerbarer Stellzylinder zwischen einer freigebenden Stellung, in der der Verbinderkopf in einer zur Kontaktierungsrichtung senkrechten Ebene bewegbar ist, in eine einspannende Stellung, in der der Verbinderkopf mittels der Spannbacken in einer vorgegebenen Lage fixiert ist, bewegbar sind. Je nach Ansteuerung der Stellzylinder, die beispielsweise als pneumatische Stellzylinder ausgeführt sein können, können auch unterschiedliche Lagen des Verbinderkopfes vorgegeben werden.

Des Weiteren wird vorzugsweise vorgeschlagen, dass das Kugelgelenk einen zylindrischen Kugelgelenksmantel aufweist, der in einer Bohrung des Verbinderrahmens mit radialem Spiel gehalten ist und eine radial abstehende Stützscheibe aufweist, die in einer Ringnut des Verbinderrahmens mit radialem Spiel und in Kontaktierungsrichtung lagefixiert angeordnet ist. Eine geringfügige Beweglichkeit des Kugelgelenksmantels hat sich nämlich insbesondere bei einer Schrägstellung der Verbindungsstecker als vorteilhaft erwiesen, wobei freilich die Lagefixierung in Kontaktierungsrichtung, also in der Längsachse des Kugelgelenksmantels, nicht beeinträchtigt werden darf. Die Ringnut des Verbinderrahmens ist dabei so ausgeführt, dass die Stützscheibe in Kontaktierungsrichtung zwar formschlüssig aufgenommen wird, dabei aber nicht festgeklemmt wird.

Zudem hat es sich als vorteilhaft erwiesen, wenn die elektrischen Versorgungskabeln des Verbinders mittels Gleitbuchsen am Verbinderrahmen gehalten sind. Auf diese Weise wird eine Beweglichkeit der Versorgungskabel in Richtung ihrer Längsachse sichergestellt, die die Beweglichkeit des Verbinderkopfes sowie die Bewegungen aufgrund der Ausrichteinheit nicht beeinträchtigt.

Die Erfindung wird in weiterer Folge anhand von Ausführungsbeispielen mithilfe der beiliegenden Figuren näher erläutert. Es zeigen hierbei die
Fig. 1 eine perspektivische Darstellung einer Ausführungsform eines erfindungsgemäßen Verbinders insbesondere für Anwendungen im Hochspannungsbereich mit dreipoligen Kontaktstiften,
Fig. 2 eine schematische Darstellung einer Ausführungsform der motorseitigen Versorgungsstecker für einen Verbinder gemäß Fig. 1,
Fig. 3 eine weitere Darstellung der Ausführungsform gemäß Fig. 1, wobei die rechte Spannbacke des Verbinders weggelassen wurde, um die mechanischen Federelemente zu zeigen,
Fig. 4 eine weitere Darstellung der Ausführungsform gemäß Fig. 1, wobei sowohl die rechte als auch die linke Spannbacke des Verbinders weggelassen wurden,
Fig. 5 einen teilweisen Schnitt durch die Ausführungsform gemäß Fig. 1 von unten gesehen, wobei insbesondere eine mögliche Anordnung des Kugelgelenks zu sehen ist,
Fig. 6a einen teilweisen Schnitt durch einen nicht von der Erfindung umfassten Verbinder insbesondere für Anwendungen im Niederspannungsbereich, und die
Fig. 6b eine weitere Darstellung der Ausführungsform gemäß Fig. 6a.

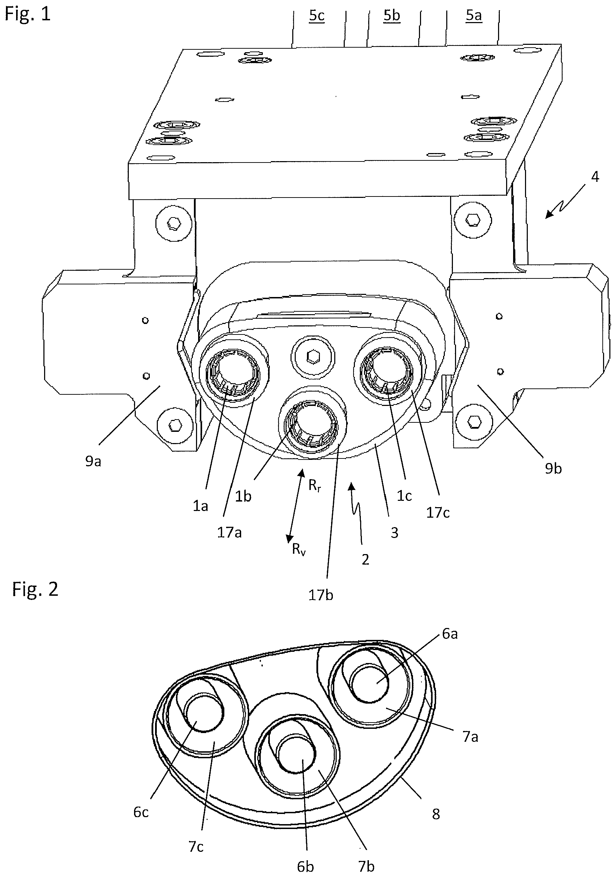

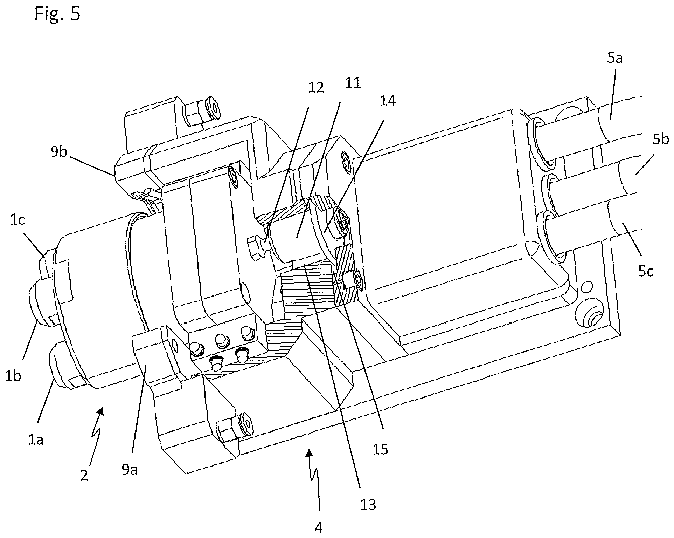

Zunächst wird auf die Fig. 1 Bezug genommen, die eine perspektivische Darstellung einer Ausführungsform eines erfindungsgemäßen Verbinders insbesondere für Anwendungen im Hochspannungsbereich mit dreipoligen Kontaktstiften 1a, 1b, 1c zeigt. Die drei Kontaktstifte 1a, 1b, 1c des Verbinders sind an einem Verbinderkopf 2 angeordnet, wobei sie von einem Rahmenteil 3 des Verbinderkopfes 2 umgeben sind. Der Verbinderkopf 2 ist in einem Verbinderrahmen 4 beweglich gelagert, wie noch näher ausgeführt werden wird. Die Kontaktstifte 1a, 1b, 1c sind jeweils mit einem elektrischen Versorgungskabel 5a, 5b, 5c des Verbinders elektrisch verbunden, die insbesondere in der Fig. 5 deutlich ersichtlich sind.

Die Kontaktstifte 1a, 1b, 1c sind am Verbinderkopf 2 jeweils federnd gelagert, und weisen im gezeigten Ausführungsbeispiel jeweils in axialer Richtung abstehende Kontaktlamellen auf, die eine Kontakthülse bilden und in radialer Richtung beweglich sind. Die Kontakthülsen sind jeweils von einer dem Kontakt zugehörigen Kunststoffhülse umgeben, wobei die Kontakthülsen innerhalb der Kunststoffhülsen relativ zu der dem Kontakt zugehörigen Kunststoffhülse axial beweglich sind. Falls die Kontakthülse mit den Kontaktlamellen relativ zur Kunststoffhülse axial verschoben wird, werden die Kontaktlamellen aufgrund einer entsprechenden Formgebung der Kunststoffhülse radial nach innen gedrückt.

Jeder der drei Kontaktstifte 1a, 1b, 1c ist des Weiteren von einer Kunststoff-Ausrichthülse 17a, 17b, 17c umgeben, die am Rahmenteil 3 befestigt sind. Die Kontaktstifte 1 mit ihren Kontaktlamellen weisen jeweils eine Längsachse auf, die eine zu den Längsachsen parallele Kontaktierungsrichtung R definieren, die in der Fig. 1 durch einen Pfeil angedeutet ist. Der Verbinder ist in der Kontaktierungsrichtung R verschiebbar, somit sind auch die Kontaktstifte 1 durch eine Bewegung des Verbinders in Kontaktierungsrichtung R bewegbar. Diese Verschiebbarkeit ermöglicht eine Vorschubbewegung, mit der die Kontaktstifte 1 mit den Versorgungssteckern 6 des Elektromotors elektrisch kontaktiert werden können, indem die Kontaktstifte 1 in eine vorwärts gerichtete Kontaktierungsrichtung Rᵥ bewegt werden. Durch eine Bewegung der Kontaktstifte 1 in eine rückwärts gerichtete Kontaktierungsrichtung Rᵣ kann der elektrische Kontakt wieder gelöst werden.

In der Fig. 2 ist eine schematische Darstellung entsprechender Versorgungsstecker 6a, 6b, 6c für einen Verbinder gemäß Fig. 1 gezeigt. Die Versorgungsstecker 6a, 6b, 6c sind jeweils stiftförmig ausgeführt und jeweils von einer ringförmigen Aufnahme 7a, 7b, 7c umgeben, die wiederum von einem motorseitigen Formteil 8 eingerahmt sind.

Die Kontaktstifte 1 des Verbinders sind von einem Rahmenteil 3 umgeben, der am Verbinderkopf 2 in Kontaktierungsrichtung R federnd gelagert ist. Dem Rahmenteil 3 ist ein entsprechend ausgeführter Formteil 8 des Elektromotors zugeordnet, der die Versorgungsstecker 6 des Elektromotors umgibt. Im Zuge einer Vorschubbewegung des Verbinders in eine vorwärts gerichtete Kontaktierungsrichtung Rᵥ trifft zunächst der verbinderseitige Rahmenteil 3 auf den motorseitigen Formteil 8, wodurch eine geringfügige Führung bewerkstelligt wird. In weiterer Folge dringen die am Rahmenteil 3 fixierten Kunststoff-Ausrichthülsen 17 und die jeweils innenliegenden, mit der Kunststoffhülse ummantelten Kontakthülsen mit den Kontaktlamellen der verbinderseitigen Kontaktstifte 1 in die motorseitig angeordneten ringförmigen Aufnahmen 7 ein, wobei die ringförmigen Aufnahmen 7 ein gewisses Maß der Führung bieten. Sobald der stiftförmige Versorgungsstecker 6 den Boden der Kontakthülse mit den Kontaktlamellen trifft, wird die Kontakthülse mit den Kontaktlamellen relativ zur Kunststoffhülse axial verschoben und die Kontaktlamellen dadurch radial nach innen gedrückt. Die Kontaktlamellen legen sich somit im Zuge der Kontaktierung von außen an den Mantel der stiftförmig ausgeführten Versorgungsstecker 6 an und stellen auf diese Weise den elektrischen Kontakt her.

Aufgrund der bereits erwähnten Produktionstoleranzen kann es dabei bei herkömmlichen Ausführungen zu Verklemmungen, einer unzureichenden Kontaktierung oder sogar zu Beschädigungen der Versorgungsstecker 6 kommen, die bei der gezeigten Ausführungsform der Fig. 1 nun vermieden werden, da der die Kontaktstifte 1 aufweisende Verbinderkopf 2 in einer zur Kontaktierungsrichtung R senkrechten Ebene beweglich gelagert ist und sich auf diese Weise im Zuge der vorwärts gerichteten Vorschubbewegung von den Versorgungssteckern 6 führen lässt. Mechanische Belastungen, Verklemmungen oder sogar Beschädigungen der Versorgungsstecker 6 können auf diese Weise vermieden werden.

Um den Verbinderkopf 2 nach dem Lösen der elektrischen Verbindung im Zuge einer Vorschubbewegung in eine rückwärts gerichtete Kontaktierungsrichtung Rᵣ wieder in eine vorgegebene Lage zu bewegen ist im gezeigten Ausführungsbeispiel der Fig. 1, 3, 4 und 5 eine aktive Ausrichteinheit zur Justierung des Verbinderkopfes 2 in diese vorgegebene Lage relativ zum Verbinderrahmen 4 vorgesehen, bei der eine vorgegebene Lage des Verbinderkopfes 2 aktiv angesteuert werden kann. Hierfür umfasst die Ausrichteinheit zwei Spannbacken 9a, 9b (siehe Fig. 1), die mittels steuerbarer Stellzylinder, die beispielsweise als pneumatische Stellzylinder ausgeführt sein können und in der Fig. 1 nicht ersichtlich sind, relativ zum Verbinderrahmen 4 verstellt werden können. Auf diese Weise können die Spannbacken 9a, 9b zwischen einer freigebenden Stellung, in der der Verbinderkopf 2 in einer zur Kontaktierungsrichtung R senkrechten Ebene bewegbar ist, in eine einspannende Stellung, in der der Verbinderkopf 2 mittels der Spannbacken 9a, 9b in einer vorgegebenen Lage fixiert ist, bewegt werden. Je nach Ansteuerung der Stellzylinder können somit unterschiedliche Lagen des Verbinderkopfes vorgegeben werden.

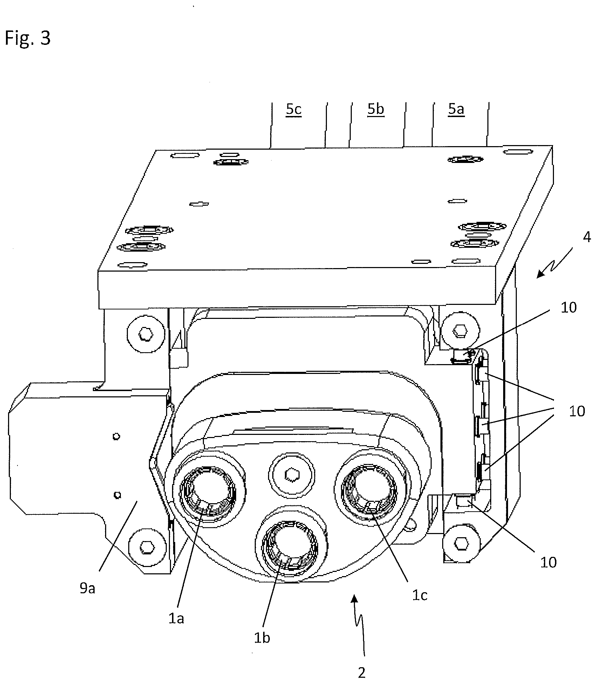

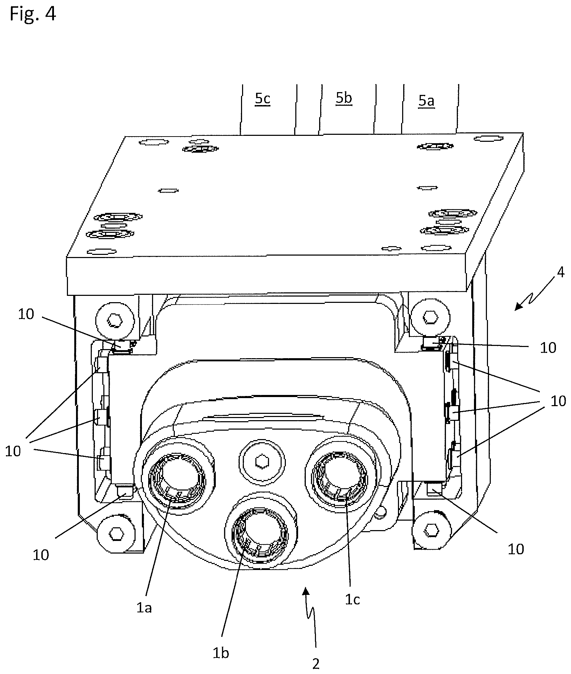

Zusätzlich zu den vorbeschriebenen, aktiven Ausrichtelementen in Form der Spannbacken 9a, 9b umfasst die Ausrichteinheit gemäß der Ausführungsform der Fig. 1, 3, 4 und 5 auch passive Ausrichtelemente, die aus einer Mehrzahl mechanischer Federelemente 10 gebildet werden und in der Fig. 3 und 4 ersichtlich sind. Die mechanischen Federelemente 10 sind jeweils zwischen dem Verbinderkopf 2 und dem Verbinderrahmen 4 auf eine Weise angeordnet, dass ihre gemeinsame Gleichgewichtslage eine vorgegebene Lage des Verbinderkopfes 2 definiert. Diese vorgegebene Lage kann freilich durch entsprechendes Verstellen der Spannbacken 9a, 9b mithilfe ihrer Stellzylinder auch verändert werden. Zumeist wird es sich bei der vorgegebenen Lage um eine Nulllage handeln, also eine definierte Anfangslage des Verbinderkopfes 2, um genau definierte Anfangsbedingungen für ein vorgegebenes Prüfprogramm sicher zu stellen.

Anhand der Fig. 5 wird eine mögliche Anordnung des Kugelgelenks 11 beschrieben. Das Kugelgelenk 11 dient zur Sicherstellung einer Beweglichkeit des Verbinderkopfes 2 in einer zur Kontaktierungsrichtung R senkrechten Ebene, sowie zur Lagefixierung des Verbinderkopfes 2 in Kontaktierungsrichtung R. In der gezeigten Ausführungsform weist das Kugelgelenk 11 einen zylindrischen Kugelgelenksmantel auf, dessen Längsachse parallel zur Kontaktierungsrichtung R angeordnet ist. Das bewegliche Gelenkselement 12 des Kugelgelenks 11 ist am Verbinderkopf 2 befestigt. Der Kugelgelenksmantel des Kugelgelenks 11 ist in einer Bohrung 13 des Verbinderrahmens 4 mit radialem Spiel gehalten und weist eine radial abstehende Stützscheibe 14 aufweist, die in einer Ringnut 15 des Verbinderrahmens 4 mit radialem Spiel und in Kontaktierungsrichtung R lagefixiert angeordnet ist. Eine geringfügige Beweglichkeit des Kugelgelenksmantels hat sich nämlich insbesondere bei einer Schrägstellung der Verbindungsstecker 6 als vorteilhaft erwiesen, wobei freilich die Lagefixierung in Kontaktierungsrichtung R, also in der Längsachse des Kugelgelenksmantels, nicht beeinträchtigt werden darf. Die Ringnut 15 des Verbinderrahmens 4 ist dabei so ausgeführt, dass die Stützscheibe 14 in Kontaktierungsrichtung R zwar formschlüssig aufgenommen wird, dabei aber nicht festgeklemmt wird.

Zudem hat es sich als vorteilhaft erwiesen, wenn die elektrischen Versorgungskabeln 5 des Verbinders mittels Gleitbuchsen am Verbinderrahmen 4 gehalten sind. Auf diese Weise wird eine Beweglichkeit der Versorgungskabel 5 in Richtung ihrer Längsachse sichergestellt, die die Beweglichkeit des Verbinderkopfes 2 sowie die Bewegungen aufgrund der Ausrichteinheit nicht beeinträchtigt.

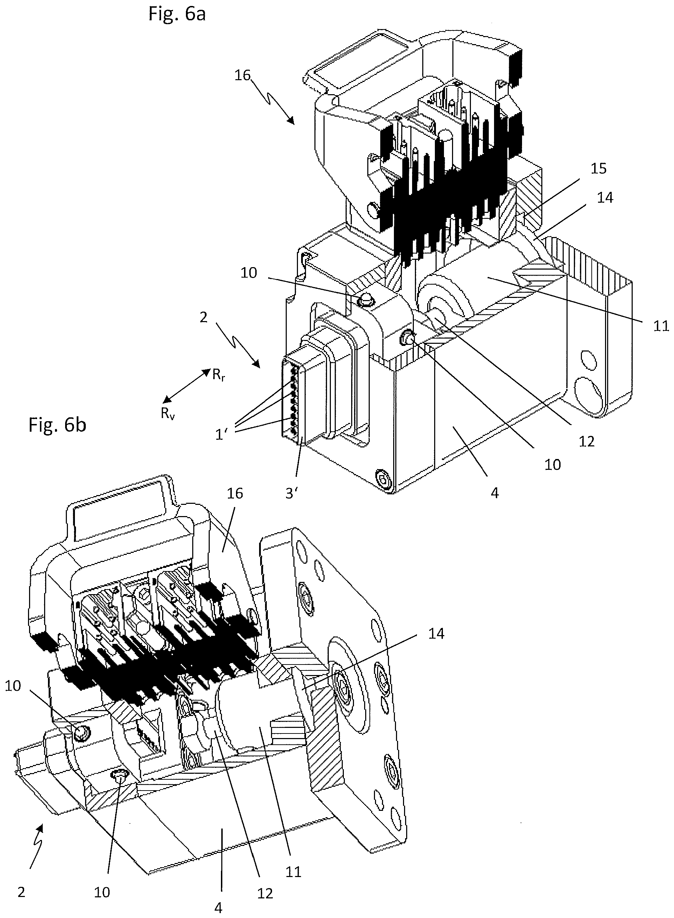

Anhand der Fig. 6 wird ein nicht von der Erfindung umfasster Verbinder insbesondere für Anwendungen im Niederspannungsbereich beschrieben. Hierbei sind eine Mehrzahl an Kontaktstiften 1' des Verbinders vorgesehen, die von einem Rahmenteil 3' umgeben sind, der im Zuge einer Vorschubbewegung in eine vorwärts gerichtete Kontaktierungsrichtung Rᵥ auf eine entsprechend ausgeführte Kontaktbuchse des Elektromotors trifft, der die Steckelemente des Elektromotors umgibt (in den Fig. 1-6 nicht ersichtlich). Der Rahmenteil 3' wird durch das Einschieben in die Kontaktbuchse ausgerichtet, sodass in weiterer Folge die Kontaktstifte 1' zielgenau an die Steckelemente stirnseitig angedrückt werden können.

Die Ausrichteinheit ist in der Ausführungsform gemäß der Fig. 6 als ausschließlich passive Ausrichteinheit ausgeführt, indem es lediglich aus einer Mehrzahl mechanischer Federelemente 10 gebildet wird, die zwischen dem Verbinderkopf 2 und dem Verbinderrahmen 4 angeordnet sind, und deren gemeinsame Gleichgewichtslage eine vorgegebene Lage des Verbinderkopfes 2 definiert. Auf diese Weise wird der Verbinderkopf 2 nach dem Lösen der elektrischen Verbindung im Zuge einer Vorschubbewegung in eine rückwärts gerichtete Kontaktierungsrichtung Rᵣ wieder in eine vorgegebene Lage relativ zum Verbinderrahmen 4 justiert.

Des Weiteren ist in der Fig. 6 auch eine an sich bekannte Prüfeinheit 16 ersichtlich, die im gezeigten Ausführungsbeispiel auch die elektrische Stromversorgung für die Kontaktstifte 1' des Verbinders beherbergt. Die Prüfeinheit 16 umfasst ferner auch eine bidirektionale Datenleitung, mit der die Prüfeinheit 16 mit einer Steuereinheit verbunden ist und Prüf- und Messdaten ausgetauscht sowie eine Ansteuerung des Verbinders vorgenommen werden können.

Mithilfe der Erfindung wird somit ein Verbinder für Motorprüfstände verwirklicht, mit dem auch bei Auftreten von Produktionstoleranzen seitens des Elektromotors ein zuverlässiger und vollständiger elektrischer Kontakt zwischen den Kontaktstiften 1 des Verbinders und den Versorgungsteckern 6 des Elektromotors hergestellt wird, aber dennoch mechanische Belastungen und somit Beschädigungen der Versorgungsstecker bestmöglich vermieden werden können.

## Patentansprüche

1. Verbinder für eine Prüfeinheit (16) eines Motorprüfstandes, wobei mit elektrischen Versorgungskabeln (5) des Verbinders elektrisch verbundene Kontaktstifte (1) des Verbinders in einer Kontaktierungsrichtung (R) zum Herstellen und Trennen eines elektrischen Kontakts zu Versorgungssteckern (6) eines zu prüfenden Elektromotors bewegbar sind, wobei der Verbinder einen Verbinderkopf (2) und einen in Kontaktierungsrichtung (R) bewegbaren Verbinderrahmen (4) umfasst, und die Kontaktstifte (1) am Verbinderkopf (2) angeordnet sind, wobei der Verbinderkopf (2) über ein Kugelgelenk (11) im Verbinderrahmen (4) in Kontaktierungsrichtung (R) relativ zum Verbinderrahmen (4) lagefixiert und in einer zur Kontaktierungsrichtung (R) senkrechten Ebene relativ zum Verbinderrahmen (4) beweglich gelagert ist, und eine Ausrichteinheit zur Justierung des Verbinderkopfes (2) in eine vorgegebene Lage relativ zum Verbinderrahmen (4) vorgesehen ist, die aus einer Mehrzahl mechanischer Federelemente (10) gebildet wird, die zwischen dem Verbinderkopf (2) und dem Verbinderrahmen (4) angeordnet sind, deren gemeinsame Gleichgewichtslage eine vorgegebene Lage des Verbinderkopfes (2) definiert, **dadurch gekennzeichnet, dass** die Ausrichteinheit Spannbacken (9) umfasst, die mittels steuerbarer Stellzylinder zwischen einer freigebenden Stellung, in der der Verbinderkopf (2) in einer zur Kontaktierungsrichtung (R) senkrechten Ebene bewegbar ist, in eine einspannende Stellung, in der der Verbinderkopf (2) mittels der Spannbacken (9) in einer vorgegebenen Lage fixiert ist, bewegbar sind.

2. Verbinder nach Anspruch 1, **dadurch gekennzeichnet, dass** das Kugelgelenk (11) einen zylindrischen Kugelgelenksmantel aufweist, der in einer Bohrung (13) des Verbinderrahmens (4) mit radialem Spiel gehalten ist und eine radial abstehende Stützscheibe (14) aufweist, die in einer Ringnut (15) des Verbinderrahmens (4) mit radialem Spiel und in Kontaktierungsrichtung (R) lagefixiert angeordnet ist.

3. Verbinder nach Anspruch 1 oder 2, **dadurch gekennzeichnet, dass** die elektrischen Versorgungskabeln (5) des Verbinders mittels Gleitbuchsen am Verbinderrahmen (4) gehalten sind.

4. Motorprüfstand mit einem Verbinder nach einem der Ansprüche 1 bis 3.

## Claims

1. Connector for a test unit (16) of a motor test bench, wherein contact pins (1) of the connector, which are electrically connected to electrical supply cables (5) of the connector, are movable in a contacting direction (R) for making and breaking an electrical contact to supply plugs (6) of an electric motor to be tested, wherein the connector comprises a connector head (2) and a connector frame (4) movable in the contacting direction (R), and the contact pins (1) are arranged on the connector head (2), wherein the connector head (2) is positionally fixed relative to the connector frame (4) in the contacting direction (R) by means of a ball joint (11) in the connector frame (4) and is movably mounted relative to the connector frame (4) in a plane perpendicular to the contacting direction (R), and an alignment unit for adjusting the connector head (2) into a predetermined position relative to the connector frame (4) is provided, which is formed by a plurality of mechanical spring elements (10) arranged between the connector head (2) and the connector frame (4), the common equilibrium position of which defines a predetermined position of the connector head (2), **characterized in that** the alignment unit comprises clamping jaws (9) which are movable by means of controllable adjusting cylinders between a releasing position, in which the connector head (2) is movable in a plane perpendicular to the contacting direction (R), and a clamping position, in which the connector head (2) is fixed in a predetermined position by means of the clamping jaws (9).

2. Connector according to claim 1, **characterized in that** the ball joint (11) has a cylindrical ball joint jacket which is held in a bore (13) of the connector frame (4) with radial play and has a radially projecting support disc (14) which is arranged in an annular groove (15) of the connector frame (4) with radial play and fixed in position in the contacting direction (R).

3. Connector according to claim 1 or 2, **characterized in that** the electrical supply cables (5) of the connector are held on the connector frame (4) by means of sliding bushes.

4. Motor test stand having a connector according to one of claims 1 to 3.

## Revendications

1. Connecteur pour une unité d'essai (16) d'un banc d'essai de moteurs, dans lequel des broches de contact (1) du connecteur connectées électriquement à des câbles électriques d'alimentation (5) du connecteur peuvent être déplacées dans une direction de mise en contact (R) pour établir et couper un contact électrique avec des connecteurs d'alimentation (6) d'un moteur électrique à l'essai, le connecteur présentant une tête de connecteur (2) et un cadre de connecteur (4) déplaçable dans la direction de mise en contact (R) et les broches de contact (1) étant disposées sur la tête de connecteur (2), dans lequel la tête de connecteur (2) est fixée dans sa position par rapport au cadre de connecteur (4) dans la direction de mise en contact (R) par une articulation à rotule (11) du cadre de connecteur (4) et supportée de façon mobile par rapport au cadre de connecteur (4) dans un plan perpendiculaire à la direction de mise en contact (R) et une unité d'orientation, composée de plusieurs éléments de ressort mécaniques (10) qui sont disposés entre la tête de connecteur (2) et le cadre de connecteur (4) et dont la position d'équilibre commune définit une position prédéterminée de la tête de connecteur (2), est prévue pour ajuster la tête de connecteur (2) dans une position prédéterminée par rapport au cadre de connecteur (4),
**caractérisé en ce que** l'unité d'orientation comprend des mors de serrage (9) qui peuvent être déplacés au moyen de vérins d'ajustement d'une position de libération, dans laquelle la tête de connecteur (2) peut être déplacée dans un plan perpendiculaire à la direction de mise en contact (R), à une position de serrage, dans laquelle la tête de connecteur (2) est fixée dans une position prédéterminée au moyen des mors de serrage (9).

2. Connecteur selon la revendication 1, **caractérisé en ce que** l'articulation à rotule (11) présente une enveloppe d'articulation à rotule cylindrique qui est retenue dans un trou percé (13) du cadre de connecteur (4) avec un jeu radial et présente une rondelle d'appui (14) qui dépasse dans le sens radial et qui est fixée en position dans la direction de mise en contact (R) avec un jeu radial dans une rainure annulaire (15) du cadre de connecteur (4).

3. Connecteur selon la revendication 1 ou 2, **caractérisé en ce que** les câbles électriques d'alimentation (5) du connecteur sont retenus sur le cadre de connecteur (4) au moyen de douilles coulissantes.

4. Banc d'essai de moteur avec un connecteur selon l'une des revendications 1 à 3.
